# EUROPÄISCHE PATENTANMELDUNG

(11) **EP 1 134 745 A1**
(43) Veröffentlichungstag der Anmeldung: **19.09.2001**
(21) Anmeldenummer: 01104593.7
(22) Anmeldetag: 06.03.2001
(51) Int. Cl.: G11C 11/4091, G11C 7/06

(54) **Leseverstärkerteilschaltung für einen DRAM-Speicher**

(30) Priorität: 06.03.2000 DE 10010886
(71) Anmelder: Infineon Technologies AG, 81669 München (DE)
(72) Erfinder: Frey Alexander, 81735 München (DE); Weber Werner Dr., 80637 München (DE)
(74) Vertreter: Reinhard - Skuhra - Weise & Partner

(57) **Zusammenfassung**

Es wird eine Leseverstärkerteilschaltung (10), beispielsweise ein N-Latch-Teil oder ein P-Latch-Teil, für einen DRAM-Speicher zum Verstärken von aus einer Bitleitung (50) ausgelesenen Spannungssignalen beschrieben, mit wenigstens zwei Bewertertransistoren (20;30), wobei das Gate (21) eines Bewertertransistors (20) mit wenigstens einer Bitleitung (50) und das Gate (31) eines anderen Bewertertransistors (30) mit wenigstens einer Referenz-Bitleitung (51) verbunden oder verbindbar ist und wobei die Drains (23,32) der Bewertertransistoren (20;30) mit den Bitleitungen (51,50) und die Sources (22,33) der Bewertertransistoren (20;30) mit einer (NCS/PCS-)Zuleitung (11) verbunden oder verbindbar sind. Wenigstens einer der beiden Bewertertransistoren (20;30) ist erfindungsgemäß derart ausgebildet, daß sich dessen Einsatzspannung während des Bewertungsvorgangs dynamisch verändert, indem die Veränderung der Gate-Spannung mit einer Veränderung der Body-Spannung gekoppelt ist. Dies kann dadurch realisiert werden, daß der Body (24;34) und das Gate (21;31) des zumindest einen Bewertertransistors (20;30) über eine Verbindung (40) miteinander verbunden sind.

## Beschreibung

Die vorliegende Erfindung betrifft zunächst eine Leseverstärkerteilschaltung für einen DRAM-Speicher gemäß dem Oberbegriff von Patentanspruch 1. Weiterhin betrifft die Erfindung einen DRAM-Speicher gemäß dem Oberbegriff von Patentanspruch 7.

DRAM-Speicher (Dynamic Random Access Memory Speicher) stellen einen wichtigen Speichertyp zum Speichern digitaler Informationen dar. Es handelt es hierbei um Speicher, bei denen man nach Vorgabe einer Adresse Daten abspeichern und unter dieser Adresse wieder auslesen kann. Dabei wird die Information als Ladungsmenge auf einer Kapazität gespeichert. Eine DRAM-Speicherzelle ist deshalb sehr einfach aufgebaut, da sie lediglich aus einer Kapazität und einem Auswahltransistor bestehen kann.

DRAM-Speicher weisen üblicherweise eine Anzahl von DRAM-Speicherzellen auf, die jeweils zu einem oder mehreren Speicherzellenfeldern (auch Arrays genannt) zusammengefaßt sind. Die einzelnen Speicherzellen werden durch Wortleitungen und Bitleitungen mit der Peripherie verdrahtet. Die Bitleitungsverdrahtung legt dabei ein Raster fest, in das auch Schreib-Leseverstärker eingefügt werden. Die Schreib-Leseverstärker haben die Aufgabe, aus den Bitleitungen ausgelesene Spannungswerte auf entsprechend vorgegebene Pegel zu verstärken, so daß diese Spannungswerte ausgewertet und in geeigneter Weise weiterverarbeitet werden können.

Zum Auslesen einer DRAM-Speicherzelle wird diese über eine Wortleitung zunächst aktiviert. Anschließend kann die Speicherzelle ausgelesen werden, indem die darin gespeicherte Information als Spannungssignal über die Bitleitung dem Schreib-Leseverstärker zugeführt wird. Um den Informationsgehalt der Speicherzelle richtig bewerten zu können, ist es weiterhin erforderlich, die über die Bitleitung der auszulesenden Speicherzelle ausgelesene Information, beziehungsweise das entsprechende Spannungssignal mit einem Referenz-Spannungssignal zu vergleichen. Dazu ist der Schreib-Leseverstärker weiterhin mit wenigstens einer Referenz-Bitleitung verbunden, die wiederum mit einer Speicherzelle verbunden ist, die gerade nicht bewertet wird.

Um die von der zu bewertenden Speicherzelle ausgelesenen Spannungssignale bewerten zu können, müssen diese entsprechend verstärkt werden. Dazu weist der Schreib-Leseverstärker in der Regel eine oder mehrere Leseverstärkerteilschaltungen auf. Die Leseverstärkerteilschaltung eines DRAM-Speichers hat die Aufgabe, ein kleines Spannungssignal, das aus dem in der Speicherzelle gespeicherten Spannungspegel resultiert, sicher und schnell auf volle Pegel zu verstärken.

Je nach Informationsgehalt der auszulesenden Speicherzelle muß der Spannungspegel auf niedrigen oder auf hohen Pegel verstärkt werden. Die Herstellung eines niedrigen Pegels (auch Low Pegel genannt) erfolgt über eine Leseverstärkerteilschaltung, die als N-Latch bezeichnet wird. Die Herstellung eines hohen Pegels (auch High Pegel genannt) erfolgt über eine als P-Latch bezeichnete Leseverstärkerteilschaltung.

Bei dem heute üblichen "Mid-Level" Bewertungsschema befindet sich der Bitleitungspegel bei Beginn der Bewertung auf halber Array-Spannung. Die Array-Spannung entspricht dabei dem High Pegel. Das bedeutet an Hand eines Beispiels, wenn der niedrige Pegel beispielsweise einen Wert von 0 Volt aufweist, und der hohe Pegel beispielsweise einen Wert von 2 Volt aufweist, daß sich der Bitleitungspegel bei Beginn der Bewertung bei 1 Volt befindet.

Üblicherweise weisen die Leseverstärkerteilschaltungen wenigstens zwei Bewertertransistoren auf, die beispielsweise, jedoch nicht ausschließlich, als sogenannte Feldeffekttransistoren ausgebildet sein können. Der Feldeffekttransistor (FET) ist ein Halbleiterbauelement mit drei Anschlüssen, die mit Gate (G), Source (S) und Drain (D) bezeichnet werden.

Eine wichtige Größe bei Feldeffekttransistoren ist die sogenannte Einsatzspannung. Hierbei handelt es sich um diejenige Spannung, ab der im Transistor ein Drain-Strom fließt, das heißt, der Transistor öffnet. Das bedeutet, daß ab der Einsatzspannung die Potentialbarriere im Transistor soweit abgebaut ist, daß ein Strom fließen kann. Wird zwischen Source und Bulk eine Sperrspannung angelegt, vergrößert sich der Wert der Einsatzspannung, da sich die Potentialbarriere vergrößert. Beim Bulk des Transistors handelt es sich um einen vierten Anschluß, der aus dem gemeinsamen Träger, meistens einem Halbleiterträger, resultiert und auch mit Substrat bezeichnet wird.

Leseverstärkerteilschaltungen für einen DRAM-Speicher zum Verstärken von aus einer Bitleitung ausgelesenen Spannungssignalen weisen in der Regel wenigstens zwei solcher Bewertertransistoren auf, wobei das Gate eines Transistors mit wenigstens einer Bitleitung und das Gate eines anderen Bewertertransitors mit wenigstens einer Referenz-Bitleitung verbunden beziehungsweise verbindbar ist. Weiterhin sind die Drains der Bewertertransistoren mit Bitleitungen und die Sources der Bewertertransistoren mit einer Zuleitung verbunden beziehungsweise verbindbar. Bei der Zuleitung, die bei N-Latch-Teilen auch als "NCS", beziehungsweise bei P-Latch-Teilen auch als "PCS" bezeichnet wird, handelt es sich um eine Leitung, über die die Leseverstärkerschaltung aktiviert wird.

Wenn sich beim "Mid-Level" Bewertungsschema der Bitleitungspegel bei Bewertungsbeginn auf ungefähr halber Array-Spannung befindet, entspricht dieser Spannungspegel auch der Gate-Source-Spannung an den Bewertertransitoren. Um die Bewertung mit der notwendigen Geschwindigkeit zu erreichen, muß die Gate-Source-Spannung um einen genügend hohen Betrag über der Einsatzspannung der Bewertertransistoren liegen. Aus Leitungsdichte- und Zuverlässigkeitsgründen wird die Array-Spannung mit kleiner werdenden Strukturgrößen, das heißt mit fortschreitenden DRAM-Generationen, nach unten skaliert. Da die Einsatzspannung der Bewertertransistoren nicht im gleichen Maße wie die Array-Spannungen verkleinert werden kann, wird der Abstand zwischen dem anfänglichen Bitleitungspegel - beispielsweise der halben Array-Spannung, die der halben Versorgungsspannung entspricht - und der Einsatzspannung der Bewertertransistoren immer geringer. Die Bewertertransistoren "öffnen" immer weniger und die Bewertung benötigt damit immer mehr Zeit. Dies ist jedoch sehr nachteilig.

Bei Verwendung von sogenannten SOI-Transistoren besteht die Möglichkeit, mit geringem Leistungsverbrauch das Substratpotential eines Transistors zu steuern. Die Bezeichnung "SOI" steht für Silicon On Insulator". Derartige Transistoren gewinnen in jüngster Zeit immer mehr an Bedeutung. SOI-Transistoren sind an sich bereits aus dem Stand der Technik bekannt.

SOI-Transistoren eröffnen die Möglichkeit, über einen Substratsteuereffekt die Einsatzspannung der Bewertertransistoren in positiver Weise für die Bewertungsgeschwindigkeit zu beeinflussen. Das Substrat, beziehungsweise der Bulk des Transistors, wird bei SOI-Transistoren auch als Body bezeichnet.

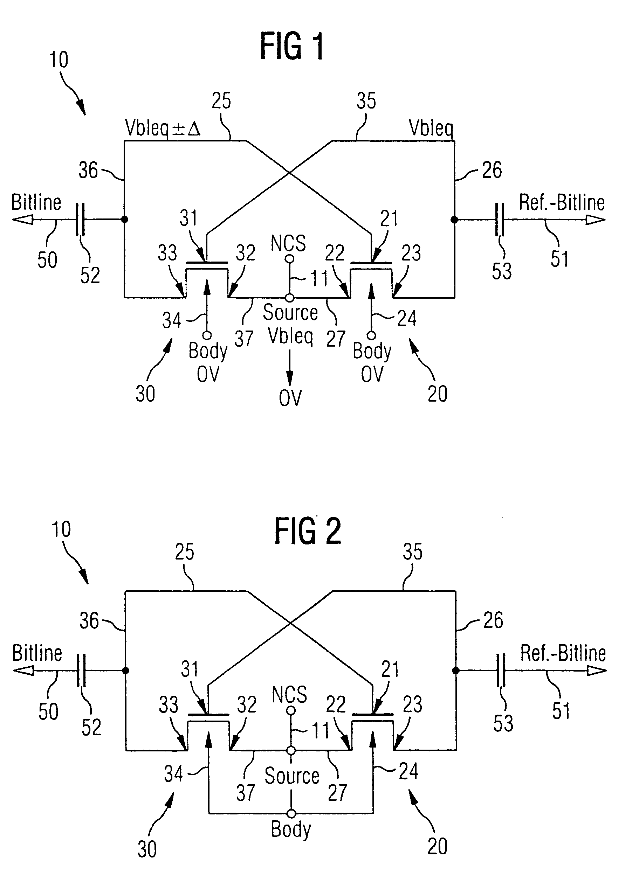

Aus dem Stand der Technik sind bereits einige Lösungsmöglichkeiten bekannt, wie die Einsatzspannung von als SOI-Transistoren ausgebildeten Bewertertransistoren über den Substratsteuereffekt beeinflußt werden kann. Diese Lösungen sind in den Figuren 1 bis 3 dargestellt und werden im Rahmen der Figurenbeschreibung näher erläutert.

Bei der in Figur 1 dargestellten Ausführungsform sind die Spannungen an der als N-Latch ausgebildeten Leseverstärkerteilschaltung eines konventionellen Leseverstärkers bei Beginn des Bewertungsvorgangs gezeigt. Zwischen Source und Body liegt eine negative Spannung, die auf Grund des Substratsteuereinflusses die Einsatzspannung der Transistoren vergrößert. Dies ist jedoch aus den oben genannten Gründen von Nachteil.

In Figur 2 ist das Prinzip des sogenannten "Body-Synchronous-Sensing" dargestellt, bei dem die unerwünschte Einsatzspannungsvergrößerung vermieden wird, indem Source und Body auf gleichem Potential gehalten werden.

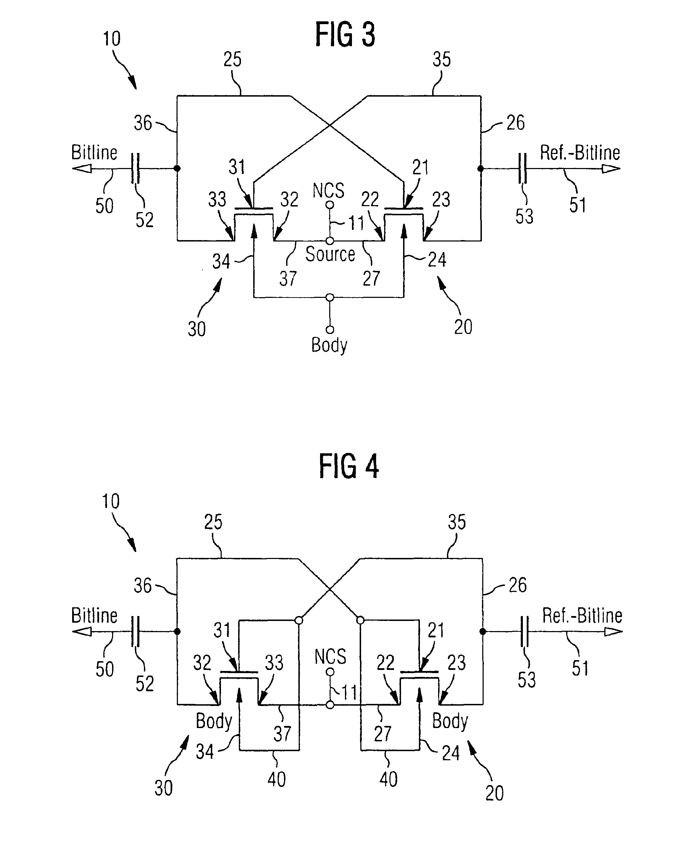

In Figur 3 ist die Beschaltung des N-Latch-Teils eines Leseverstärkers beim sogenannten "Super-Body-Synchronous-Sensing" dargestellt. Über eine separate Leitung kann die Body-Spannung eingestellt werden. Bei Beginn der Bewertung wird die Body-Spannung so eingestellt, daß die Source-Body-Spannung positiv wird und damit über den Substratsteuereinfluß die Einsatzspannung der Bewertertransistoren verringert wird. Eine positive Source-Body-Spannung bedeutet allerdings, daß die Source-Bulk-Dioden in Flußrichtung gepolt sind. Das Sensing-Schema läßt sich deshalb nur für Spannungspegel anwenden, bei denen der resultierende Vorwärtsstrom so klein ist, daß er sich nicht nachteilig auswirkt. Die letztgenannte Lösung ist beispielsweise in dem Aufsatz "SOI-DRAM Circuit Technologies for Low Power High Speed Multi Giga Scale Memories" von Kuge et al., IEEE Journal of Solit-State-Circuits, Vol. 31, number 4, April 1996, Seiten 586 ff beschrieben.

Ausgehend vom genannten Stand der Technik liegt der vorliegenden Erfindung die Aufgabe zu Grunde, eine Leseverstärkerteilschaltung für einen DRAM-Speicher sowie einen DRAM-Speicher derart weiter zu verbessern, daß die Bewertung der Speicherzellen auch bei kleinen Array-Spannungen in akzeptabel kurzer Zeit durchgeführt werden kann.

Diese Aufgabe wird gelöst durch die Leseverstärkerteilschaltung gemäß Patentanspruch 1, den DRAM-Speicher gemäß Patentanspruch 7 sowie eine vorteilhafte Verwendung der Leseverstärkerteilschaltung gemäß Patentanspruch 8. Weitere vorteilhafte Merkmale, Aspekte und Details der Erfindung ergeben sich aus den abhängigen Ansprüchen, der Beschreibung und den Zeichnungen. Vorteile und Merkmale, die in Bezug auf die Leseverstärkerteilschaltung beschrieben sind, gelten ebenso für den DRAM-Speicher, und Vorteile und Merkmale, die in Bezug auf den DRAM-Speicher beschrieben sind, gelten ebenso für die Leseverstärkerteilschaltung. Analoges gilt für die erfindungsgemäße Verwendung.

Gemäß dem ersten Aspekt der vorliegenden Erfindung wird eine Leseverstärkerteilschaltung für einen DRAM-Speicher zum Verstärken von aus einer Bitleitung ausgelesenen Spannungssignalen bereitgestellt, mit wenigstens zwei Bewertertransistoren, wobei das Gate eines Bewertertransistors mit wenigstens einer Bitleitung und das Gate eines anderen Bewertertransistors mit wenigstens einer Referenz-Bitleitung verbunden oder verbindbar ist und wobei die Drains der Bewertertransistoren mit Bitleitungen und die Sources der Bewertertransistoren mit einer Zuleitung verbunden oder verbindbar sind. Die Leseverstärkerteilschaltung ist erfindungsgemäß dadurch gekennzeichnet, daß zumindest einer der Bewertertransistoren derart ausgebildet ist, daß sich dessen Einsatzspannung während des Bewertungsvorgangs dynamisch verändert, indem die Veränderung der Gate-Spannung mit einer Veränderung der Bulk-Spannung gekoppelt ist.

Durch die erfindungsgemäße Leseverstärkerteilschaltung wird es möglich, die DRAM-Speicherzellen auch bei kleinen Array-Spannungen in akzeptabel kurzer Zeit zu bewerten.

Der verstärkende Effekt der erfindungsgemäßen Leseverstärkerteilschaltung wird nachfolgend an Hand eines N-Latch-Teils verdeutlicht. Dieser Effekt beruht zum einen darauf, daß der Bewertertransistor mit der höheren Gate-Spannung eine an seine Drain angeschlossene Kapazität schneller nach 0 Volt entlädt als der Bewertertransistor mit der geringeren anfänglichen Gate-Spannung. Der schneller absinkende Bitleitungspegel koppelt wiederum auf das Gate des ohnehin schlechter leitenden Transistors und schließt diesen weiter.

Dieser verstärkende Effekt wird erfindungsgemäß nun dadurch vergrößert, daß sich die Einsatzspannung des besser leitenden Transistors dynamisch verkleinert, während sich die Einsatzspannung des schlechter leitenden Transistors dynamisch vergrößert.

Diese dynamische Veränderung wird dadurch realisiert, daß die Veränderung der Gate-Spannung mit einer Veränderung der Bulk-Spannung gekoppelt ist. Dies bedeutet, daß sich die Bulk-Spannung gleichzeitig mit der Veränderung der Gate-Spannung ändert. Der besser leitende Transistor wird sehr viel schneller noch besser leitend, während der schlechter leitende Transistor sehr viel schneller noch schlechter leitend wird. Dadurch kann die Bewertungszeit erheblich reduziert werden.

Ein Vorteil der erfindungsgemäßen Leseverstärkerschaltung gegenüber dem aus dem Stand der Technik bekannten "Super-Body-Synchronous-Sensing" besteht darin, daß die erfindungsgemäße Leseverstärkerteilschaltung ohne zusätzliche Steuerleitungen, etwa für die N- und P-Bodies der P- und N-Latches, auskommt. Das Timing für die Ansteuerung der Bodies (Bulks) kann somit entfallen. Erst dadurch wird die dynamische Änderung der Einsatzspannung des wenigstens einen Bewertertransistors ermöglicht, da sich die Body-Spannung gleichzeitig und in direkter Abhängigkeit von der Gate-Spannung ändert.

Für kleine Array-Spannungen, die bei Technologiegenerationen mit F=70nm etwa 0,6 bis 0,9 Volt und für F=50nm etwa 0,5 bis 0,6 Volt betragen können, ermöglicht die erfindungsgemäße Leseverstärkerteilschaltung eine beschleunigte Bewertung im Vergleich zu konventionellen Leseverstärkerteilschaltungen. Als F wird in diesem Fall die minimale lithographische Strukturgröße verstanden.

Vorteilhaft kann die dynamische Änderung der Einsatzspannung dadurch realisiert werden, daß der Bulk (beziehungsweise der Body) und das Gate des zumindest einen Bewertertransistors über eine Verbindung miteinander verbunden sind.

Vorzugsweise ist die Source-Drain-Diode des zumindest einen Bewertertransistors in Flußrichtung gepolt. Wie beim "Super-Body-Synchronous-Sensing" läßt sich das erfindungsgemäße Schema deshalb für solche Spannungspegel anwenden, bei denen der resultierende Vorwärtsstrom so klein ist, daß er sich nicht nachteilig auswirkt.

Vorteilhaft kann die erfindungsgemäße Leseverstärkerteilschaltung als Schaltung zur Herstellung des Low-Pegels (N-Latch) und/oder als Schaltung zur Herstellung des High-Pegels (P-Latch) ausgebildet sein.

Der wenigstens eine Bewertertransistor kann vorteilhaft als SOI-Transistor ausgebildet sein. Solche SOI-Transistoren sind deshalb besonders geeignet, da man ein separates Gebiet benötigt, das den Bulk-Bereich (Body-Bereich) bildet. Bei auf herkömmliche Weise hergestellten Transistoren wäre die Erzeugung eines solchen Body-Bereichs zwar auch möglich, allerdings mit wesentlich mehr Aufwand und damit mit wesentlich höheren Kosten, so daß die Verwendung von SOI-Transistoren präferiert wird.

Gemäß einem zweiten Aspekt der vorliegenden Erfindung wird ein DRAM-Speicher bereitgestellt mit einer Anzahl von DRAM-Speicherzellen, die über Bitleitungen mit wenigstens einem Schreib-Leseverstärker verbunden sind, wobei der Schreib-Leseverstärker ebenfalls mit wenigstens einer Referenz-Bitleitung verbunden ist, dadurch gekennzeichnet, daß der Schreib-Leseverstärker zur Verstärkung von aus einer Bitleitung ausgelesenen Spannungssignalen eine oder mehrere wie vorstehend beschriebene erfindungsgemäße Leseverstärkerteilschaltung(en) aufweist.

Auf diese Weise wird es möglich, die einzelnen Speicherzellen des DRAM-Speichers auch bei kleinen Array-Spannungen in akzeptabel kurzer Zeit bewerten zu können.

Besonders bevorzugt wird eine wie vorstehend beschriebene erfindungsgemäße Leseverstärkerteilschaltung zum Bewerten kleiner Array-Spannungen von ≤ 1 Volt verwendet.

Die Erfindung wird nun an Hand von Ausführungsbeispielen unter Bezugnahme auf die beiliegende Zeichnung näher erläutert. Es zeigen:
Figur 1 die Schaltungsanordnung eines N-Latch Teils eines konventionellen Leseverstärkers mit den bei Beginn des Bewertungsvorgangs anliegenden Spannungen;
Figur 2 eine Schaltungsanordnung des N-Latch Teils eines konventionellen Leseverstärkers beim Body-Synchronous-Sensing;
Figur 3 eine Schaltungsanordnung des N-Latch Teils eines herkömmlichen Leseverstärkers beim Super-Body-Synchronous-Sensing; und
Figur 4 eine Schaltungsanordnung des N-Latch Teils einer erfindungsgemäßen Leseverstärkerteilschaltung.

In Figur 1 ist eine Leseverstärkerteilschaltung 10 dargestellt, wie sie aus dem Stand der Technik bekannt ist. Die Leseverstärkerteilschaltung 10 weist zwei Bewertertransistoren 20, 30 auf, wobei die Bewertertransistoren 20, 30 jeweils über ein Gate 21, 31, eine Source 22, 32, ein Drain 23, 33 sowie einen Bulk 24, 34 verfügen. Die Bewertertransistoren 20, 30 sind als sogenannte SOI-Transistoren ausgebildet, so daß der Bulk auch als Body bezeichnet wird und diese Bezeichnung im weiteren Verlauf der Figurenbeschreibung genutzt wird.

Das Gate 21 des Bewertertransistors 20 ist über eine Verbindung 25 (VBLEQ ±Δ) mit einer Bitleitung (Bitline) 50 verbunden. Das Gate 31 des Bewertertransistors 30 ist über eine Verbindung (VBLEQ) 35 mit einer Referenz-Bitleitung (Ref. Bitline) 51 verbunden.

Die Sources 22, 32 der Bewertertransistoren 20, 30 sind über entsprechende Verbindungen 27, 37 mit einer Zuleitung 11 verbunden, die im vorliegenden beispielsweise eine sogenannte NCS-Leitung ist, über die die Leseverstärkerteilschaltung 10, die als N-Latch-Teil ausgebildet ist, aktiviert wird.

Die Drains 23, 33 der Bewertertransistoren 20, 30 sind über entsprechende Verbindungen 26, 36 mit den Bitleitungen 50, 51 verbunden und stehen mit Kapazitäten 52, 53 in Kontakt.

Nachfolgend wird nun die Funktionsweise dieser aus dem Stand der Technik bekannten Leseverstärkerteilschaltung 10 beschrieben. Angenommen, bei der Leseverstärkerteilschaltung 10 handelt es sich um einen sogenannten N-Latch, dessen Aufgabe darin besteht, ein aus der Bitleitung 50 ausgelesenes Spannungssignal auf den Low-Level zu verstärken. Dieser Low-Level kann beispielsweise 0 Volt betragen. Zu Beginn des Bewertungsvorgangs befindet sich der Bitleitungspegel auf allen Bitleitungen, das heißt im Ausführungsbeispiel auf der Bitleitung 50 sowie der Referenz-Bitleitung 51, auf ungefähr halber Array-Spannung VBLEQ. Da die zu bewertende DRAM-Speicherzelle einen Informationsgehalt hat, ist das Spannungssignal auf der auszulesenden Bitleitung um einen bestimmten Betrag Δ je nach Informationsgehalt in der Zelle entweder vergrößert oder verkleinert.

Angenommen, der Spannungswert ist um einen Betrag Δ vergrößert, so bedeutet dies, daß nach Beginn des Bewertungsvorgangs am Gate 21 des Transistors 20 eine höhere Spannung anliegt, als dies am Gate 31 des Transistors 30 der Fall ist. Auf Grund der höheren Spannung am Gate 21 leitet der Transistor 20 besser. Dadurch sinkt das Potential von der NCS-Zuleitung 11 besser und schneller über den Transistor 20 ab. Durch diesen Effekt sowie durch die Tatsache, daß der Transistor 30 auf Grund der geringeren Gate-Spannung ohnehin schlechter leitet, wird die Leitung im Transistor 30 mit zunehmendem Bewertungszeitverlauf immer schlechter, während die Leitung im Transistor 20 immer besser wird.

Um bei der Leseverstärkerteilschaltung 10 gemäß Figur 1 eine Bewertung mit einer ausreichend hohen Geschwindigkeit erreichen zu können, muß die Gate-Source-Spannung an den Transistoren 20, 30 um einen genügend hohen Betrag über der Einsatzspannung der Transistoren 20, 30 liegen. Mit zunehmender Verkleinerung der DRAM-Speicher-Strukturen wird aus Leistungsdichte- und Zuverlässigkeitsgründen die Array-Spannung jedoch immer weiter reduziert. Allerdings kann die Einsatzspannung der Bewertertransistoren 20, 30 nicht in gleichem Maße wie die Array-Spannung verkleinert werden, wodurch der Abstand zwischen diesen beiden Spannungen immer geringer wird. Die Bewertertransistoren 20, 30 öffnen immer weniger, weshalb die Bewertung immer mehr Zeit erfordert.

Bei dem in Figur 1 dargestellten Ausführungsbeispiel kommt weiterhin hinzu, daß zwischen den Sources 22, 32 und den Bodies 24, 34 der Bewertertransistoren 20, 30 jeweils eine negative Spannung anliegt, die auf Grund des Substratsteuereinflusses die Einsatzspannung der Bewertertransistoren 20, 30 vergrößert.

Die in Figur 1 dargestellte herkömmliche Leseverstärkerteilschaltung 10 ist deshalb nicht geeignet, Bewertungen von DRAM-Speicherzellen bei kleinen Array-Spannungen von ≤ 1 Volt in akzeptabel kurzer Zeit durchführen zu können.

Um eine unerwünschte Einsatzspannungsvergrößerung bei den Bewertertransistoren 20, 30 vermeiden zu können, wurde das sogenannte Body-Synchronous-Sensing entwickelt, das in Figur 2 dargestellt ist. Die in Figur 2 dargestellte Leseverstärkerteilschaltung 10 entspricht in ihrem Grundaufbau sowie in ihrer Grundfunktionsweise der in Figur 1 dargestellten Leseverstärkerteilschaltung 10, so daß identische Bauelemente mit gleichen Bezugsziffern versehen sind. Weiterhin wird zur Vermeidung von Wiederholungen auf eine erneute Beschreibung verzichtet und auf die Ausführungen zum Ausführungsbeispiel gemäß Figur 1 verwiesen.

Im Unterschied zur Ausführungsform gemäß Figur 1 wird bei der in Figur 2 dargestellten Leseverstärkerteilschaltung 10 die unerwünschte Einsatzspannungsvergrößerung bei den Bewertertransistoren 20, 30 dadurch vermieden, daß die Sources 22, 32 und Bodies 24, 34 der Bewertertransistoren 20, 30 auf gleichem Potential gehalten werden. Dazu sind die Sources 22, 32 und Bodies 24, 34 miteinander verbunden und damit unabhängig von der NCS-Spannung auf gleichem Potential.

In Figur 3 ist die Beschaltung einer Leseverstärkerteilschaltung 10, beispielsweise des N-Latch-Teils des Leseverstärkers, beim bekannten Super-Body-Synchronous-Sensing dargestellt. Der Grundaufbau sowie die Grundfunktionsweise der Leseverstärkerteilschaltung 10 entsprechen wiederum den in Figur 1 und 2 dargestellten Ausführungsbeispielen, so daß gleiche Bautelemente wiederum mit identischen Bezugsziffern versehen sind und zur Vermeidung von Wiederholungen auf die Beschreibung zu den Figuren 1 und 2 verwiesen wird.

Im Unterschied zu den in Figur 1 und 2 dargestellten Ausführungsformen können die Bodies 24, 34 der Bewertertransistoren 20, 30 über eine separate Leitung auf ein bestimmtes Potential gelegt werden. Bei Beginn der Bewertung wird die Body-Spannung so eingestellt, daß die Source-Body-Spannung positiv wird. Über den Substratsteuereinfluß kann damit die Einsatzspannung der Bewertertransistoren 20, 30 verringert werden. Nachteilig bei dieser Ausführungsform ist jedoch, daß zusätzliche Steuerleitungen erforderlich sind, um die Body-Spannung einstellen zu können. Weiterhin müssen Regelschaltungen vorgesehen werden, die das Timing für das Ansteuern der Bodies 24, 34 regeln.

Um auf einfache, kostengünstige und dennoch zuverlässige Weise eine akzeptable Bewertung von DRAM-Speicherzellen auch bei kleinen Array-Spannungen realisieren zu können, wird erfindungsgemäß eine modifizierte Leseverstärkerteilschaltung 10 vorgeschlagen, wie sie beispielsweise in Figur 4 dargestellt ist. In Figur 4 ist das Prinzip der erfindungsgemäßen Leseverstärkerteilschaltung 10 an Hand des N-Latch-Teils gezeigt. Die Leseverstärkerteilschaltung 10 kann jedoch analog auch als P-Latch-Teil ausgebildet sein und fungieren. Wiederum entspricht der Grundaufbau und die Grundfunktionsweise der Leseverstärkerteilschaltung 10 den in den Figuren 1 bis 3 dargestellten Ausführungsbeispielen, so daß wiederum gleiche Bauelemente mit identischen Bezugsziffern versehen sind. Ebenso wird auf die Beschreibung im Hinblick auf die Figuren 1 bis 3 Bezug genommen.

Erfindungsgemäß ist die Leseverstärkerteilschaltung 10 derart ausgebildet, daß sich die Einsatzspannungen der beiden Bewertertransistoren 20, 30 in Abhängigkeit ihrer Gate-Spannungen beziehungsweise von den Bitleitungspegeln ändern. Dazu sind die Gates 21, 31 und Bodies 24, 34 der Bewertertransistoren 20, 30 jeweils über eine Verbindung 40 miteinander verbunden.

Der verstärkende Effekt der Leseverstärkerteilschaltung 10 beruht nun einerseits darauf, daß der Bewertertransistor 20 mit der höheren Gate-Spannung (zum besseren Verständnis werden wiederum die im Hinblick auf das Beispiel gemäß Figur 1 genannten Bedingungen angenommen) die an seine Drain 23 angeschlossene Kapazität 53 schneller nach 0 Volt entlädt als der Bewertertransistor 30 mit der geringeren anfänglichen Gate-Spannung. Der schneller absinkende Bitleitungspegel koppelt wiederum auf das Gate 31 des ohnehin schlechter leitenden Transistors 30 und schließt diesen weiter.

Bei der erfindungsgemäßen Leseverstärkerteilschaltung 10 wird der verstärkende Effekt nunmehr dadurch vergrößert, daß sich die Einsatzspannung des besser leitenden Transistors 20 wegen der Verbindung 40 zwischen dem Body 24 und dem Gate 21 dynamisch verkleinert, während sich die Einsatzspannung des schlechter leitenden Transistors 30 dynamisch vergrößert.

Über die Verbindung 40 ist die Veränderung der Gate-Spannung mit der Veränderung der Body-Spannung gekoppelt, so daß der besser leitende Bewertertransistor 20 sehr viel schneller noch besser leitend wird, während der ohnehin schlechter leitende Bewertertransistor 30 sehr viel schneller noch schlechter leitend wird.

## Patentansprüche

1. Leseverstärkerteilschaltung für einen DRAM-Speicher zum Verstärken von aus einer Bitleitung (50) ausgelesenen Spannungssignalen, mit wenigstens zwei Bewertertransistoren (20; 30), wobei das Gate (21) eines Bewertertransistors (20) mit wenigstens einer Bitleitung (50) und das Gate (31) eines anderen Bewertertransistors (30) mit wenigstens einer Referenz-Bitleitung (51) verbunden oder verbindbar ist und wobei die Drains (23, 33) der Bewertertransistoren (20; 30) mit den bitleitungen (51, 50) und die Sources (22, 32) der Bewertertransistoren (20; 30) mit einer Zuleitung (11) verbunden oder verbindbar sind,
**dadurch gekennzeichnet,**
**daß** zumindest einer der Bewertertransistoren (20; 30) derart ausgebildet ist, daß sich dessen Einsatzspannung während des Bewertungsvorgangs dynamisch verändert, indem die Veränderung der Gate-Spannung mit einer Veränderung der Bulk-Spannung gekoppelt ist.

2. Leseverstärkerteilschaltung nach Anspruch 1,
**dadurch gekennzeichnet,**
**daß** der Bulk ( 24; 34) und das Gate (21, 31) des zumindest einen Bewertertransistors (20; 30) über eine Verbindung (40) miteinander verbunden sind.

3. Leseverstärkerteilschaltung nach Anspruch oder 2,
**dadurch gekennzeichnet,**
**daß** die Source-Drain-Diode des zumindest einen Bewertertransistors (20; 30) in Flußrichtung gepolt ist.

4. Leseverstärkerteilschaltung nach einem der Ansprüche 1 bis
3, **dadurch gekennzeichnet,**
**daß** diese als Schaltung zur Herstellung des Low-Pegels (N-Latch) ausgebildet ist.

5. Leseverstärkerteilschaltung nach einem der Ansprüche 1 bis
3, **dadurch gekennzeichnet,**
**daß** diese als Schaltung zur Herstellung des High-Pegels (P-Latch) ausgebildet ist.

6. Leseverstärkerteilschaltung nach einem der Ansprüche 1 bis
5, **dadurch gekennzeichnet,**
**daß** der wenigstens eine Bewertertransistor (20; 30) als SOI-Transistor ausgebildet ist.

7. DRAM-Speicher mit einer Anzahl von DRAM-Speicherzellen, die über Bitleitungen mit wenigstens einem Schreib-Leseverstärker verbunden sind, wobei der Schreib-Leseverstärker ebenfalls mit wenigstens einer Referenz-Bitleitung verbunden ist,
**dadurch gekennzeichnet,**
**daß** der Schreib-Leseverstärker zur Verstärkung von aus einer Bitleitung ausgelesenen Spannungssignalen eine oder mehrere Leseverstärkerteilschaltung(en) (10) nach einem der Ansprüche 1 bis 6 aufweist.

8. Verwendung einer Leseverstärkerteilschaltung nach einem der Ansprüche 1 bis 6 zum Bewerten kleiner Array-Spannungen von ≤ 1 Volt.
